# EUROPEAN PATENT APPLICATION

(11) **EP 3 868 926 A2**
(43) Date of publication of application: **25.08.2021**
(21) Application number: 21154619.7
(22) Date of filing: 01.02.2021
(51) Int. Cl.: C30B 25/18, C30B 25/20, C30B 29/04, C23C 16/04, C23C 16/27

(54) **DIAMOND BASED GEM AND METHOD OF MAKING SAME**

(30) Priority: 03.02.2020 US 202062969244 P
(71) Applicant: Capsoul Diamond Ltd., 7194900 Alei Zahav (IL)
(72) Inventor: DAMRI, Nirit, 7194900 Alei Zahav (IL); DAMRI, Talchaim, 7194900 Alei Zahav (IL)
(74) Representative: Pearl Cohen Zedek Latzer Baratz UK LLP

(57) **Abstract**

A diamond-based gem is disclosed. The diamond-based gem may include, at least one first portion comprising one of: a single crystal diamond and a transparent polycrystal diamond; and at least one second portion comprising opaque polycrystal diamond. Further are disclosed several methods for manufacturing such a diamond-based gem.

## Description

### FIELD OF THE INVENTION

This invention is related to the field of artificial diamonds and more specifically to the field of polycrystal artificial diamonds.

### BACKGROUND OF THE INVENTION

Diamonds, either natural or artificial, are a luxurious product that is being used mainly in the jewelry industry but also in other applications, such as, sensors, detectors and the like. Decorative diamonds are single crystals, polished to a desired shape. The more perfect the crystal of the diamond is, the higher is its value.

Artificial diamonds are produced using either high-pressure high-temperature (HPHT) methods or chemical vapor deposition (CVD) methods. When using CVD methods, a diamond is grown from a hydrocarbon gas mixture. The CVD method allows to grow diamonds over large areas and on various substrates.

One of the byproducts of manufacturing of artificial diamonds is the formation of opaque polycrystal diamonds, usually at the edges of a transparent polycrystal or single crystal diamond. These opaque polycrystal diamonds are grown uncontrolled and are usually removed at the end of the production process to form a clear transparent diamond. Currently used methods of manufacturing gems, in particular for decorative purposes (e.g., as an ornament or to be included in any fashion item) is to eliminate as much as possible the formation of these undesired opaque polycrystal diamonds.

There is need for a successful method for controlling the growth and formation of the opaque polycrystal diamonds with the single crystal diamond in order to form a novel type of diamond-based gem that includes both : single crystal diamond or transparent polycrystal diamond and these desired opaque polycrystal diamonds.

### SUMMARY OF THE INVENTION

Some aspects of the invention may be directed to a diamond-based gem comprising, at least one first portion comprising one of: a single crystal diamond and a transparent polycrystal diamond; and at least one second portion comprising opaque polycrystal diamond. In some embodiments, one of the at least one first portion at least partially encapsulates one or more of the at least one second portion. In some embodiments, the at least one second portion forms a frame around at least part of the at least one first portion.

In some embodiments, the gem may include a plurality of first portions and a plurality of second portions having a predetermined shape.

Some additional aspects of the invention may be related to a method of forming a diamond-based gem comprising: providing one of:
(a) a seed, the seed comprising:
   at least one first portion adapted to grow thereon at least one of: a single crystal diamond or a transparent polycrystal diamond, and
   at least one second portion adapted to grow thereon an opaque polycrystal diamond; and
(b) two or more seeds, wherein:
   at least a first type of seed of the two or more seeds is adapted to grow thereon at least one of: a single crystal diamond or a transparent polycrystal diamond.

In some embodiments, the method may further include growing, using a chemical vapor deposition (CVD) process: at least one first portion of the gem comprising one of: a single crystal diamond or a transparent polycrystal diamond on the first portion of the seed.

In some embodiments, the method may further include growing at least one second portion of the gem comprising opaque polycrystal diamond of the second portion of the seed. In some embodiments, the at least one second portion adapted to grow thereon an opaque polycrystal diamond is provided by forming on a seed adapted to grow thereon at least one of: a single crystal diamond or a transparent polycrystal diamond the second portion is by one of, causing defects in the second portions and applying diamond powder. In some embodiments, the method may further include growing at least one second portion of the gem comprising opaque polycrystal diamond adjacent to at least one first portion.

In some embodiments, the at least one second portion of the gem is formed by one of, controllably causing defects to an area in one of the first portions and applying diamond powder to the area of the one of the first portions. In some embodiments, at least one second portion of the gem is formed by one of, controllably causing defects to an area in one of the first portions and applying diamond powder to the area of the one of the first portions.

In some embodiments, the second type of diamond is the opaque polycrystal diamond, and the method may further include: forming a pattern on the surface of the initial portion; and growing the opaque polycrystal diamond on the pattern.

Some additional aspects of the invention may be related to a method of forming a diamond-based gem, comprising: providing at least one initial portion of a first type of diamond; masking a first mask pattern on at least one surface of the at least one initial portion; growing the first type or a second type of diamond on the unmasked area of the at least one initial portion; and removing the first mask pattern. In some embodiments, growing the first or second types is by a chemical vapor deposition (CVD) process. In some embodiments, the first type is an opaque polycrystal diamond and the second type is one of: a single crystal diamond and a transparent polycrystal diamond, or *vice versa.*

In some embodiments, the method may further include masking a second mask pattern on at least one other surface of the at least one initial portion; and growing, the other type not previously grown of diamond on the unmasked portion of the surface. In some embodiments, the method may further include growing, an additional portion the first type of diamond on top of at least a part of the second type of diamond. In some embodiments, the first type of diamond at least partially encapsulates the second type of diamond. In some embodiments, the first portion is provided by one of: (a) a natural diamond; and (b) a first type of diamond grown on one or more seeds by one of: a chemical vapor deposition (CVD) process and a high temperature high pressure (HTHP) process.

In some embodiments, growing the first type of diamond is by using a first set of growing conditions, and growing, the second type of diamond is by using a second set of growing conditions. In some embodiments, the second type of diamond is the opaque polycrystal diamond, and the method may further include: forming a pattern on the surface of the initial portion; and growing the opaque polycrystal diamond on the pattern. In some embodiments, forming the pattern is by causing defects in the diamond, for example, by one of: laser ablation, , ion milling, diamond knife and hot stamping or by applying diamond powder. In some embodiments, the method may further include providing mold; and growing the gem inside the mold.

Some additional aspects of the invention may be related to a method of forming a diamond-based gem, comprising: providing at least one initial portion of a first type of diamond; modifying at least a first portion of the surface of the at least one initial portion; growing a second type of diamond on the modified first portion of the surface; and growing the first type of diamond on an unmodified portion of the surface. In some embodiments, growing the first and second types is by a chemical vapor deposition (CVD) process. In some embodiments, modifying the surface is by one of: laser ablation, applying diamond powder, ion milling, diamond knife, hot stamping and the like. In some embodiments, the first type is an opaque polycrystal diamond and the second type is one of: a single crystal diamond and a transparent polycrystal diamond, or *vice versa.*

Some additional aspects of the invention may be related to a method forming a diamond-based gem, comprising: providing at least one initial portion of a first type of diamond; and growing a second type of diamond, on top of the initial portion, by applying a first set of growing conditions. In some embodiments, the first type is an opaque polycrystal diamond and the second type is one of: a single crystal diamond and a transparent polycrystal diamond, or *vice versa.* In some embodiments, the method may further include: growing, an addition portion of the first type of diamond, on top of the second type of diamond by applying a second set of growing parameters.

Some additional aspects of the invention may be related to a method forming a diamond-based gem, comprising: providing a mold to a growing chamber, the mold comprising one of: a seed, diamond powder and graphite for growing at least one diamond; and growing the gem inside the mold using one of: a chemical vapor deposition (CVD) process and a high temperature high pressure (HTHP) process.

In some embodiments, the seed and growing parameters are selected for growing a single crystal diamond. In some embodiments, the seed and growing parameters are selected for growing a transparent polycrystal diamond. In some embodiments, the seed and growing parameters are selected for growing an opaque polycrystal diamond.]

### BRIEF DESCRIPTION OF THE DRAWINGS

The subject matter regarded as the invention is particularly pointed out and distinctly claimed in the concluding portion of the specification. The invention, however, both as to organization and method of operation, together with objects, features, and advantages thereof, may best be understood by reference to the following detailed description when read with the accompanying drawings in which:
Fig. 1 is a flowchart of a method of making diamond- based gem according to some embodiments of the invention;
Figs. 2A-2C are illustrations of diamond seeds according to some embodiments of the invention;
Fig. 3 is an illusration of a diamond- based gem according to some embodiments of the invention;
Figs. 4A and 4B are two parts of a flowchart of a method of making diamond- based gem according to some embodiments of the invention;
Figs. 5 presents illustrations of various steps in the production of diamond-based gem according to some embodiments of the invention;
Fig. 6 is an illustration of a diamond-based gem according to some embodiments of the invention;
Fig. 7 is an illustration of a diamond-based gem according to some embodiments of the invention;
Figs. 8A-8C are illustrations of a diamond-based gem according to some embodiments of the invention;
Fig. 9 is a flowchart of a method of making diamond- based gem according to some embodiments of the invention; and
Fig. 10 is a flowchart of a method of making diamond- based gem according to some embodiments of the invention.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

### DETAILED DESCRIPTION OF THE PRESENT INVENTION

In the following detailed description, numerous specific details are set forth in order to provide a thorough understanding of the invention. However, it will be understood by those skilled in the art that the present invention may be practiced without these specific details. In other instances, well-known methods, procedures, and components have not been described in detail so as not to obscure the present invention.

Aspects of the invention may be related to a gem made from at least two different portions, one of them is transparent and may include a single crystal diamond or a transparent polycrystal. In some embodiments, the other portion may include an opaque polycrystal diamond. In some embodiments, both the opaque portion and the transparent portion may have a predetermined, predesigned shape. Other aspects of the invention may include various methods of forming such gems.

Additional aspects of the invention may include growing a diamond-based gem inside a mold, such that the gem may adopt the shape of the mold.

As used herein the term "single crystal diamond" may refer to a diamond comprising only one crystal lattice with no internal grain boundaries.

As used herein the term "transparent polycrystal diamond" may refer to a diamond comprising a plurality of crystals, grown as a single gem or a single portion of a gem, that may allow at least a portion of the visible light (e.g., EM radiation in the visible light spectrum) to pass through the gem. A transparent polycrystal diamond may be fully transparent or partially transparent. A fully transparent polycrystal diamond is a diamond gem that allow the entire visible light spectrum pass through the diamond gem. A partially transparent polycrystal diamond is a diamond gem that blocks a portion of the visible light spectrum from passing through the diamond gem. In some embodiments, partially transparent polycrystal diamond may allow only specific wavelength to pass through the diamond gem resulting in a colored gem (e.g., a red transparent diamond). In some embodiments, the transparency may be controlled by controlling the size of the crystals in the polycrystal diamond. In a nonlimiting example, each crystal size in the polycrystal diamond may be less than 50-500 nm. In some embodiments, controlling the size of the polycrystals may be conducted by controlling the diamond growing parameters. In some embodiments, the transparency may be controlled (e.g., by controlling the growing parameters) by controlling the amount of graphite (e.g., Sp2 carbon) in the grain boundaries of the diamond (e.g., Sp3 carbon) grains (e.g., crystals).

As used herein the term "opaque polycrystal diamond" may include a polycrystal diamond that due the size of the crystals in the polycrystal does not allow visible light to pass, thus look at least partially dark (e.g., a black diamond). In some embodiments, opaque polycrystal diamond may include carbonado diamond comprising: diamond, graphite, and/or amorphous carbon.

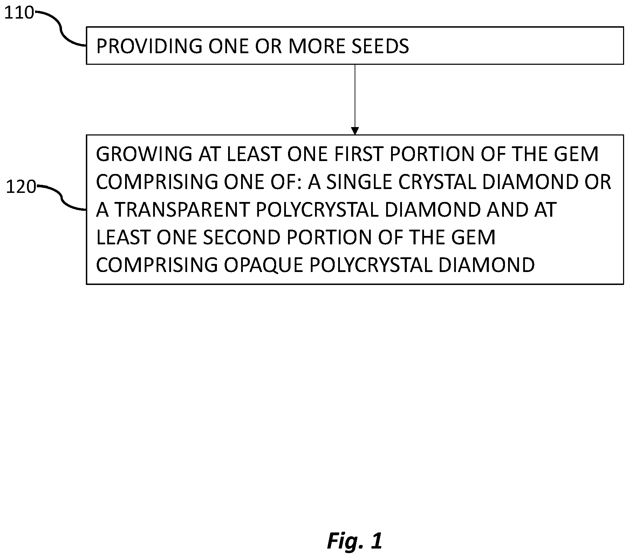

As used herein the term "gem" may refer to a diamond-based single stone made at least partially by artificial methods (e.g., CVD and HPHT). Such a gem may include a plurality of diamond crystals elements which are not connected, glued or attached by any artificial or additional material but only due to covalence force. The attachment of the plurality of diamond crystals to each other may result from the CVD and/or HPHT fabrication methods only. A gem according to embodiments of the invention may include only diamonds (or other carbon allotropes) with no bonding force other than a covalence force forms between carbon atoms. The gem according to embodiments of the invention may refer to a stone to be used for decoration purposes of an ornament, a fashion accessory (e.g., a watch, a wallet, etc.) and the like. The gem according to embodiments of the invention may also include point defects in the diamond crystal, for example, vacancies, interstitial atoms, substitutional atoms and the like. The point defects may affect the color of the diamond. Reference is now made to Fig. 1 which is a flow of a first method of forming a diamond-based gem according to some embodiments of the invention. In step 110 one or more seeds may be provided. For example, a single crystal seed, according to embodiments of the invention, may have any crystallographic orientation, which may affect the selection of growing conditions.

In some embodiments, if only one seed is provided, the seed may include at least one first portion adapted to grow thereon at least one of: a single crystal diamond or a transparent polycrystal diamond, and at least one second portion adapted to grow thereon an opaque polycrystal diamond. In some embodiments, if two or more seeds are provided at least a first type of seed of the two or more seeds may be adapted to grow thereon at least one of: a single crystal diamond or a transparent polycrystal diamond, and at least one second type of seed of the two or more seeds may be adapted to grow thereon an opaque polycrystal diamond.

In some embodiments, a single crystal diamond seed having at least one portion adapted to growth thereon a poly crystal may be used to growth only polycrystal diamond.

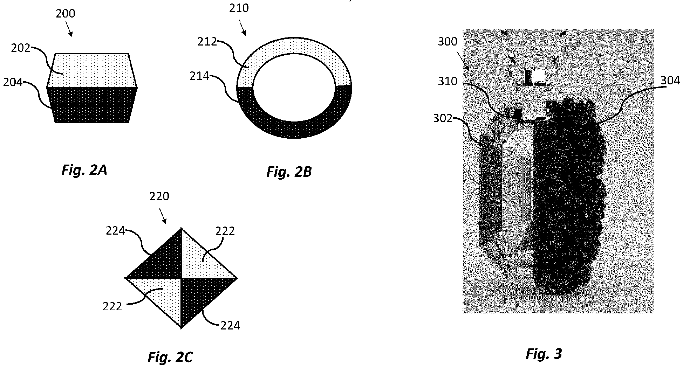

Some examples of such seeds according to some embodiments of the invention are illustrated in Figs. 2A-2C. In some embodiments, each of seeds 200, 210 and 220 may include at least two portions each configured to grow thereon a different type of diamond. For example, portions 202, 212 and 222 of the corresponding seeds 200, 210 and 220 may be configured to grow thereon a single crystal diamond or a transparent polycrystal diamond. In this example, portions 204, 214 and 224 of the corresponding seeds 200, 210 and 220 may be configured to grow thereon an opaque polycrystal diamond. Alternatively, element 202, 212 and 222 of the corresponding multi seeds 200, 210 and 220 may each represent a first type of seed configured to grow thereon a single crystal diamond or a transparent polycrystal diamond. Therefore, elements 204, 214 and 224 may each represent a second type of seed configured to grow thereon an opaque polycrystal diamond. As should be understood by one skilled in the art, the seeds shapes illustrated in Figs. 2A-2C are given as nonlimiting examples. Accordingly, seeds having at least two different portions according to embodiments of the invention may have any desired shape and/or geometry and the at least two different portions may have, each, any desired shape and/or geometry.

In some embodiments, several methods may be used to form the at least one second portion adapted to grow thereon an opaque polycrystal diamond (e.g., portions 204, 214 and 224). Nonlimiting examples for making such a seed may include: providing a seed adapted to grow thereon at least one of: a single crystal diamond or a transparent polycrystal diamond and deforming or reforming the surface of the seed by causing defects in the diamond, for example, by one of: laser ablation, , ion milling, diamond knife, hot stamping and the like or applying diamond powder. In some embodiments, portions 204, 214 and 224 may include a silicon wafer.

In step 120 of Fig. 1, at least one first portion of the gem and at least one second portion of the gem may be grown on the seed or the two or more seeds using a chemical vapor deposition (CVD) process. In some embodiments, the at least one first portion of the gem may include one of: a single crystal diamond or a transparent polycrystal diamond grown on the first portion of the seed or a first type of seed, and the at least one second portion of the gem may include opaque polycrystal diamond grown on the second portion of the seed or a second type of seed or adjacent to at least one first portion. An illustration of nonlimiting example, of such gem is given in Fig. 3, which is explained in detail below.

For example, seeds (or multi-seeds) 200, 210 and 220 may be inserted into a CVD reactor. In some embodiments, a gem may be grown by introducing a hydrocarbon gas mixture into the reactor. In some embodiments, the hydrocarbon gas may be energized and ionized into chemically active radicals in the CVD reactor. The energizing may be conducted using any one of: microwave power, a hot filament, an arc discharge, a welding torch, a laser, an electron beam, and the like. In some embodiments, the CVD process may be conducted at a temperature of 800-1200 °C of the seed. In some embodiments, the CVD process may be conducted at temperatures lower than 800 °C. In some embodiments, the CVD process may be conducted at temperatures higher than 1000 °C. In such case, decreasing the temperature may lead to changing of the growth rate and may lead to the need to adapted additional parameters of the process (e.g., pressure, power, gas mixture and the like).

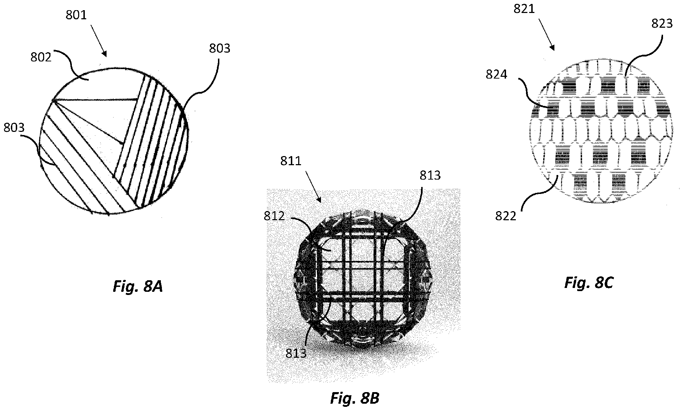

In some embodiments, the at least one second portion of the gem may be formed by one of, controllably causing defects to an area in one of the first portions and applying diamond powder to the area of the one of the first portions. For example, a plurality of transparent seeds may be provided to form a plurality of transparent portions and the opaque portions may be formed by controllably causing defects in boundaries between two transparent portions, as illustrated in Fig. 8A and 8C. Reference is now made to Fig. 3 which is an illusration of a gem produced according to some embodiments of the invention. A gem 300 may be fabricated using, for example, the method of Fig. 1 or using any other method disclosed herein below. Gem 300 includes at least one first portion 302 including one of: a single crystal diamond and a transparent polycrystal diamond, and at least one second portion 304 comprising opaque polycrystal diamond. In some embodiments, at least one first portion 302 may be grown on at least one first portion of a seed adapted to grow thereon at least one of: a single crystal diamond or a transparent polycrystal diamond. Alternatively, at least one first portion 302 may be grown a first type of a seed adapted to grow thereon at least one of: a single crystal diamond or a transparent polycrystal diamond. In some embodiments, at least one second portion 304 may be grown on at least one second portion of a seed adapted to grow thereon opaque polycrystal diamond. Alternatively, at least one second portion 304 may be grown on at least one second type of seed adapted to grow thereon opaque polycrystal diamond. In some embodiments, portion 302 may be cut and polished and portion 304 may be left unpolished, as illustrated.

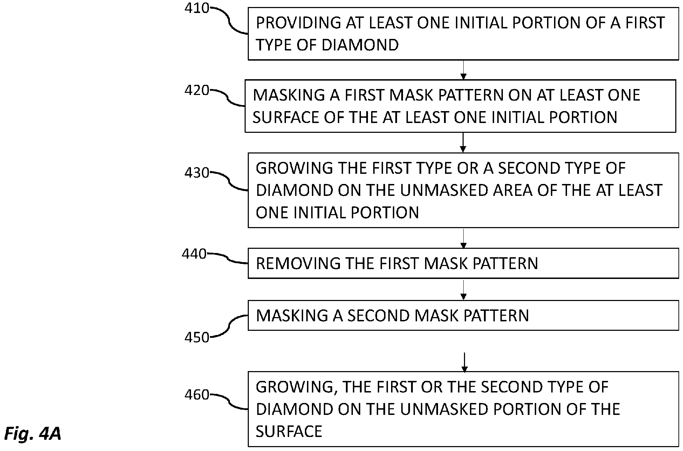

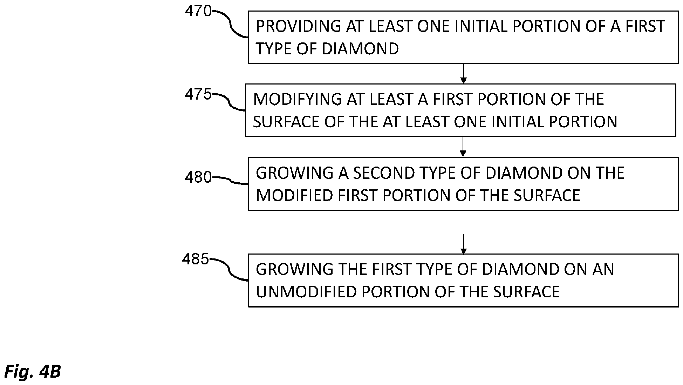

In some embodiments, gem 300 may include an embedded cavity 310 (e.g., a predesigned hole) for an insertion of a metallic necklace connector and the like. In some embodiments, such a cavity or cavities may be formed by using a masking method, for example, the masking method discussed with respect to the method of Figs. 4A and 4B below.

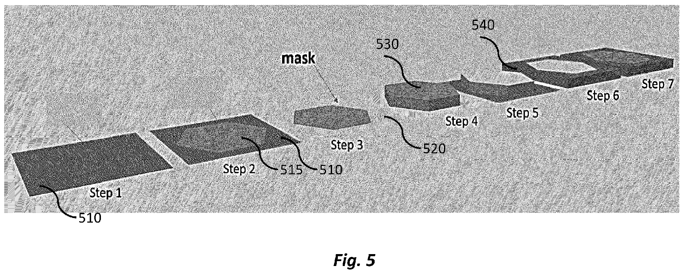

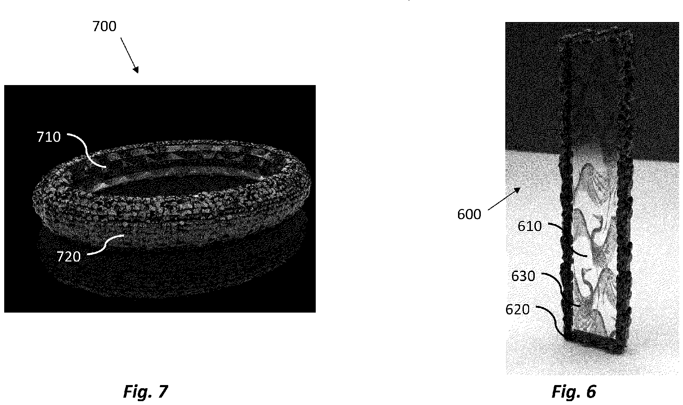

Reference is now made to Fig. 4A which is a schematic flow chart of a second method of forming a diamond-based gem according to some embodiments of the invention. The method of Fig. 4A may be best understood together with the illustrations of the method steps illustrated in Fig. 5. In step 410, at least one initial portion (e.g., one, two or more initial portions) of a first type of diamond may be provided (510 of Fig. 5). In some embodiments, at least one initial portion of: a single crystal diamond or a transparent polycrystal diamond may be provided. Alternatively, at least one initial portion of an opaque polycrystal diamond may be provided. In some embodiments, a first portion of the single crystal diamond may be provided as a natural diamond or may be grown on a single crystal seed using a CVD process or a HPHT process. A first portion of the transparent polycrystal diamond or the opaque polycrystal diamond may be grown on a polycrystal seed (as discussed herein above with respect to the method of Fig. 1) using a CVD process or a HPHT process. An illusration of such an initial portion 510 is shown in step 1 of Fig. 5. In some embodiments, if initial portion 510 includes a single crystal diamond or a transparent polycrystal diamond, a pattern 515 for growing opaque polycrystal diamond may be formed the surface of initial portion 510, illustrated in step 2 of Fig. 5 The pattern may be formed using any method known in the art, for example, laser ablation, applying diamond powder, ion milling, diamond knife, hot stamping and the like. In some embodiments, the pattern may be a drawing, for example, the birds drawing illustrated in Fig 6, which is discussed in detail below.

In step 420, a first mask pattern may be disposed on at least one surface of the at least one initial portion (or more than one initial portions). In some embodiments, the first mask pattern may have any predetermined shape. For example, a first mask pattern 520, illustrated in step 3 of Fig. 5 may be applied on top of the nonpatterned area of initial portion 510. In some embodiments, the first mask pattern may include any known masking material, for example, Al, Ti, Au, SiO₂, Si₃N₄ and the like, applied using any known method, for example, CVD .

In step 430, a second type or the first type of diamond may be grown on the unmasked area of the at least one initial portion. For example, if initial portion 510 is a single crystal diamond or a transparent polycrystal diamond, an opaque polycrystal diamond 530 may be grown on the unmask portion illustrated in step 4 of Fig. 5. Alternatively, if the initial portion is an opaque polycrystal diamond, a single crystal diamond or a transparent polycrystal diamond may be grown on the unmask portion of the opaque polycrystal diamond. In some embodiments, the opaque polycrystal diamond or the single crystal diamond or the transparent polycrystal may be grown using a CVD method, as disclosed with respect to the method of Fig. 1 herein above.

In step 440, the first mask pattern may be removed, using any known method, for example, by chemical etching.

In some embodiments, the method of Fig. 4 may further include in step 450, disposal of a second mask pattern. In some embodiments, the second mask pattern may cover at least one other surface of the at least one initial portion. In some embodiments, the second mask pattern may be disposed on at least a portion of the diamond grown in step 440. In some embodiments, the second mask pattern may be shaped according to any predetermined design. For example, a second mask pattern 550 may be disposed on top of opaque polycrystal diamond 530 illustrated in step 5 Fig. 5. In some embodiments, the second mask pattern may include any known masking material, for example, Al, Ti, Au, SiO₂, Si₃N₄ and the like, applied using any known method, for example, CVD.

In step 460, the first or the second type of diamond may be grown on the unmasked portion of the surface, for example, using CVD methods as disclosed herein above. For example, a single crystal diamond or a transparent polycrystal diamond 560, illustrated in step 6 Fig. 5, may be grown on the unmasked portion of the surface of initial portion 510, as to form a single crystal or a transparent polycrystal diamond that includes both portion 510 and portion 560. Alternatively, an opaque polycrystal diamond may be grown on the unmasked portion of the surface of the initial portion as to form a single opaque polycrystal diamond. In some embodiments, the first type of diamond may at least partially encompass the second type of diamond.

In some embodiments, the method may further include growing, an additional portion of the first type of diamond on top of at least a part of the second type of diamond. For example, additional portion 570 illustrated in step 4 of Fig. 5. In some embodiments, additional portion 570 may include a single crystal or a transparent polycrystal diamond, such that opaque polycrystal diamond 530 may be completely encapsulated inside the single crystal or the transparent polycrystal diamond.

In some embodiments, the method of Fig. 4 may include growing the first type of diamond is by using a first set of growing conditions and growing, the second type of diamond is by using a second set of growing conditions. For example, the conditions for growing a single crystal diamond in a CVD chamber may include, temperatures between 800-1200 °C (e.g., of the growing gem) CH₄/H₂ ratio 4-10 %. In order to grow transparent polycrystal diamond or opaque polycrystal diamond the above conditions may be altered. For example, the temperature may be changed, the gas pressure and/or the gas ratio may be changed. In some embodiments, the intensity of the plasma may be increased or decreased, the distance of the target from the plasma may be changed that the size and shape of the stage carrying the target may also be changed. In some embodiments, the target may include the seed, the initial portion and/or the growing portion(s).

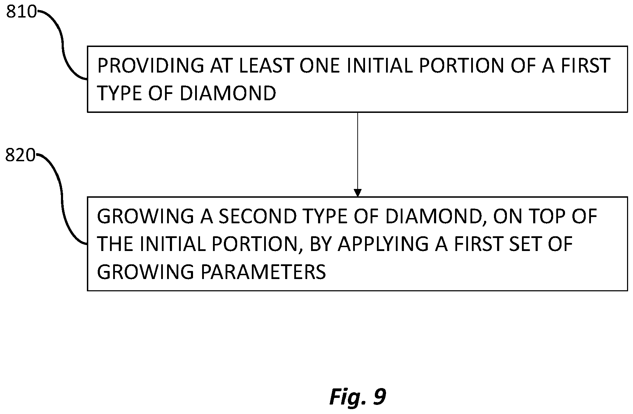

In some embodiments, at least some of steps 410-470 may be performed inside a mold for providing the shape of the mold to the gem, as discussed in detail with respect to the method Fig. 9.

Reference is now made to Fig. 4B which is a third method of forming a diamond-based gem according to some embodiments of the invention. The method of Fig. 4B may also be best understood together with the illustrations of the method steps illustrated in Fig. 5. Step 470 may be substantially the same as step 410 of the method of Fig. 4A. In step 475, at least a first portion of the surface of the at least one initial portion may be modified. In some embodiments, modifying the surface is by one of: laser ablation, applying diamond powder, ion milling, diamond knife, hot stamping and the like. For example, portion 515 in step 2 of Fig. 5 may be modified.

In step 480, a second type of diamond may be grown on the modified first portion of the surface and in step 485 the first type of diamond may be grown on an unmodified portion of the surface. For example, an opaque diamond 530 may be grown on modified portion 515 and a transparent diamond 540 may be grown on the unmodified portion, as illustrated in Fig 5. In some embodiments, growing the first and second types is by a chemical vapor deposition (CVD) process, using any one of the conditions disclosed herein above. In some embodiments, the first type is an opaque polycrystal diamond and the second type is one of: a single crystal diamond and a transparent polycrystal diamond, or *vice versa.*

In some embodiments, an additional portion that includes the first or second types may be grown on the first and/or second types of diamonds.

Reference is now made to Fig. 6 which is an illusration of a gem according to some embodiments of the invention. A gem 600 may be formed using the method of Fig. 4 and optionally Fig. 1 disclosed herein above. Gem 600 may include at least one first portion 610 comprising one of: a single crystal diamond and a transparent polycrystal diamond and at least one second portion 620 and/or 630 comprising opaque polycrystal diamond.

In some embodiments, at least one first portion 610 at least partially encapsulates one or more of the at least one second portion 630. In some embodiments, at least one second portion 630 may have a designed pattern, for example, the flying birds illustrated in Fig. 6, embedded in a transparent first portion 610.

In some embodiments, at least one second portion 620 may form a frame around at least part of at least one first portion 610. In some embodiments, the farm may be a complete frame (as illustrated) or a partial frame.

Reference is now made to Fig. 7 which is an illusration of a gem according to some embodiments of the invention. A gem 700 may be formed using the method of Fig. 4A and optionally Fig. 1 disclosed herein above. Gem 700 may include a ring-like portion 710 comprising transparent polycrystal diamonds and a plurality of opaque polycrystal diamonds 720 covering portion 710. In some embodiments, gem 700 may be formed using a ring-shaped seed.

In some embodiments, a gem may include an internal pattern made from opaque polycrystal diamond encapsulated by a transparent polycrystal diamond or a single crystal diamond, *or vise versa..*

In some embodiments, a gem may include two or more layers (e.g., alternating) having a first type of layer made from a transparent polycrystal diamond or a single crystal diamond and a second type of layer made from opaque polycrystal diamond. A method of making such gem is disclosed in the flowchart of Fig. 9.

Reference is now made to Figs. 8A, 8B and 8C which are illustrations of gems according to some embodiments of the invention. Gems 801, 811 and 821 may be made according to any of the methods disclosed herein. Gem 801, illustrated in Fig. 8A may include a plurality of first portions 802 each comprising a transparent polycrystal diamond or a single crystal diamond, and a plurality of second portions 803 comprising opaque polycrystal diamond. Second portions 803 may be created in the boundaries between each two first portions 802 making these boundaries visible. In some embodiments, at least some of first portions 802 may be colored.

Gem 811 illustrated in Fig. 8B may include one or more of first portions 812 each comprising a transparent polycrystal diamond or a single crystal diamond and one or more second portions 813 comprising opaque polycrystal diamond, at least partially encapsulating one or more first portions 812. In some embodiments, one or more second portions 813 may form a decorative net on the surface of one or more first portions 812. In some embodiments, one or more of first portions 812 may be colored.

Gem 821 illustrated in Fig. 8C may include one or more of first portions 822 each comprising a transparent polycrystal diamond or a single crystal diamond and one or more second portions 823 and 824 comprising opaque polycrystal diamond, at least partially encapsulating one or more first portions 822. In some embodiments, one or more second portions 823 and 824 may form a decorative net on the surface of one or more first portions 812. In some embodiments, one or more of first portions 822 may be colored.

In some embodiments, both the first and second portions of gems 801, 811 and 821 may be polished.

Reference is now made to Fig. 9 which is a flowchart of a method for forming a diamond-based gem according to some embodiments of the invention. In step 810, at least one initial portion of a first type of diamond may be provided. In some embodiments, step 810 may be substantially the same as step 410 of the method of Fig. 4. In step 820, a second type of diamond (different than the first) may be grown on top of the initial portion, by applying a first set of growing conditions. In some embodiments, the first type is an opaque polycrystal diamond and the second type is one of: a single crystal diamond and a transparent polycrystal diamond, or *vice versa.* For example, the conditions for growing a single crystal diamond in a CVD chamber may include, temperatures between 800-1200 °C and CH₄/H₂ ratio 4-10 %. In order to grew transparent polycrystal diamond or opaque polycrystal diamond the above conditions may be altered. For example, the temperature may be changed, the gas pressure and/or the gas ratio may be changed. In some embodiments, the intensity (e.g., voltage)of the plasma may be increased or decreased, the distance of the target from the plasma may be changed that the size and shape of the stage carrying the target may also be changed.. In some embodiments, the target may include the seed, the initial portion and/or the growing portion(s)..

Additionally or alternatively, if the initial portion is a transparent diamond, the method may include reforming the surface of the initial portion, by for example, causing defects in the diamond, for example, by one of: laser ablation, , ion milling, diamond knife, hot stamping and the like or by applying diamond powder.

In some embodiments, the method may further include growing, an addition portion of the first type of diamond, on top of the second type of diamond by applying a second set of growing conditions. Additionally or alternatively, if the second type of diamond is a transparent diamond, the method may include reforming the surface of the second type of diamond, by for example, causing defects in the diamond, for example, by one of: laser ablation, ion milling, diamond knife, hot stamping and the like or by applying diamond powder.

Some aspects of the invention may be related to forming an artificial diamond-based gem inside a mold. In such case the gem may receive the form of the mold. In some embodiments, the mold may have any desired shape, for example, a ring, a triangle, a cone and the like. In some embodiments, the mold may be made from a metals or ceramics, for example, molybdenum.

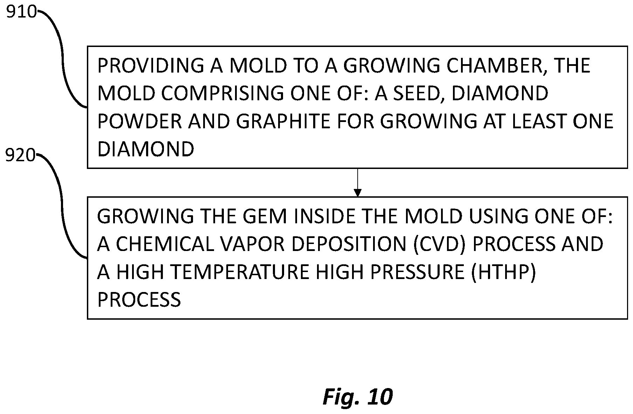

Reference is now made to Fig. 10 which is a flowchart of a method of forming a diamond-based gem inside a mold according to some embodiments of the invention. In step 910, a mold may be provided to a growing chamber, for example, a CVD chamber or high temperature high pressure (HTHP) chamber. In some embodiments, a diamond seed, diamond powder and/or graphite may be provided to the mold, depends on the type of diamond to be grown. The seed may be seed adapted to grow thereon at least one of: a single crystal diamond or a transparent polycrystal diamond or a seed adapted to grow thereon an opaque polycrystal diamond. The later can be a Si seed or may include diamond powder, graphite source and the like.

In step 920, the gem may be grown inside the mold using one of: the chemical vapor deposition (CVD) process and the high temperature high pressure (HTHP) process. In some embodiments, the seed and growing conditions are selected for growing a single crystal diamond. In some embodiments, the seed and growing conditions are selected for growing a transparent polycrystal diamond. the seed and growing conditions are selected for growing a transparent polycrystal diamond wherein the seed and growing conditions are selected for growing an opaque polycrystal diamond.

Some additional aspects of the invention may be related to a shaped seed for growing a single type of artificial diamond. For example, a ring-like seed may be used for growing a ring-shaped diamond. In some embodiments, the ring-like seed may be one of: a seed adapted to grow thereon at least one of: a single crystal diamond, a transparent polycrystal diamond or an opaque polycrystal diamond. In some embodiments, any other shaped seed may be used for growing shaped diamond-based gem.

While certain features of the invention have been illustrated and described herein, many modifications, substitutions, changes, and equivalents will now occur to those of ordinary skill in the art. It is, therefore, to be understood that the appended claims are intended to cover all such modifications and changes as fall within the true spirit of the invention.

## Claims

1. A method of forming a diamond-based gem comprising:
providing one of:
(a) a seed, the seed comprising:
at least one first portion adapted to grow thereon at least one of: a single crystal diamond or a transparent polycrystal diamond, and
at least one second portion adapted to grow thereon an opaque polycrystal diamond; and
(b) two or more seeds, wherein:
at least a first type of seed of the two or more seeds is adapted to grow thereon at least one of: a single crystal diamond or a transparent polycrystal diamond; and
growing, using a chemical vapor deposition (CVD) process:
at least one first portion of the gem comprising one of: a single crystal diamond or a transparent polycrystal diamond on the first portion of the seed.

2. The method of claim 1, further comprising growing at least one second portion of the gem comprising opaque polycrystal diamond of the second portion of the seed.

3. The method of claim 2 wherein the at least one second portion adapted to grow thereon an opaque polycrystal diamond is provided by forming on a seed adapted to grow thereon at least one of: a single crystal diamond or a transparent polycrystal diamond the second portion is by one of, causing defects in the second portions and applying diamond powder.

4. The method of claim 1, further comprising growing at least one second portion of the gem comprising opaque polycrystal diamond adjacent to at least one first portion.

5. The method of claim 4, wherein the at least one second portion of the gem is formed by one of, controllably causing defects to an area in one of the first portions and applying diamond powder to the area of the one of the first portions.

6. The method of claim 4, wherein at least one second portion of the gem is formed by one of, controllably causing defects to an area in one of the first portions and applying diamond powder to the area of the one of the first portions.

7. A method of forming a diamond-based gem according to any one of claims 1 to 6 wherein the second type of diamond is the opaque polycrystal diamond, and the method further comprises:
forming a pattern on the surface of the initial portion; and
growing the opaque polycrystal diamond on the pattern.

8. A diamond-based gem comprising:
at least one first portion comprising one of: a single crystal diamond and a transparent polycrystal diamond; and
at least one second portion comprising opaque polycrystal diamond.

9. The diamond-based gem of claim 8, wherein one of the at least one first portion at least partially encapsulates one or more of the at least one second portion.

10. The diamond-based gem of claim 8, wherein the at least one second portion forms a frame around at least part of the at least one first portion.

11. The diamond-based gem of claim 8, comprising a plurality of first portions and a plurality of second portions having a predetermined shape.
